# EUROPEAN PATENT APPLICATION

(11) **EP 1 113 095 A1**
(43) Date of publication of application: **04.07.2001**
(21) Application number: 00128417.3
(22) Date of filing: 27.12.2000
(51) Int. Cl.: C30B 13/00, C30B 13/32

(54) **FZ Method single crystal growing apparatus**

(30) Priority: 27.12.1999 JP 37007199
(71) Applicant: SHIN-ETSU HANDOTAI COMPANY LIMITED, Chiyoda-ku Tokyo (JP)
(72) Inventor: Hirahara, Kazuyuki, Saigata P. Shin-Etsu Handotai, Kubiki-mura, Nakakubiki-gun, Niigata-ken (JP); Nakazawa, Keiichi, Saigata P. Shin-Etsu Handotai, Kubiki-mura, Nakakubiki-gun, Niigata-ken (JP)
(74) Representative: Wibbelmann, Jobst, Dr., Dipl.-Chem.

(57) **Abstract**

There is disclosed a single crystal growing apparatus by a floating-zone method (FZ method) characterized by comprising at least a polycrystal set chamber, zoning chamber, single crystal take-out chamber, and three work floors, which are installed near the chambers and corresponding to positions of at least each work plane for setting a polycrystal, zoning, and taking out a single crystal. There can be provided an FZ method single crystal growing apparatus, wherein in order to avoid a risk of operations in high positions, resulting that a raw material polycrystal and single crystal rod are much heavier and longer, to clean up a single crystal growing atmosphere and work environment, and to reduce an idling time, problems as for the apparatus can be solved, so that reliability of work can be improved, and power saving and improvement of productivity can be achieved.

## Description

### BACKGROUND OF THE INVENTION

### Field of the Invention:

The present invention relates to the structure of an FZ method single crystal growing apparatus for growing a single crystal rod by a floating-zone method (FZ method) .

### Description of the Related Art:

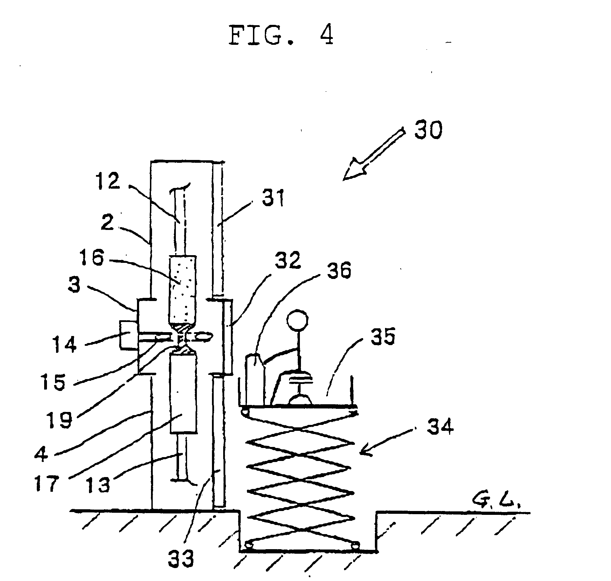

For example, Fig. 4 shows one example of a conventional FZ method single crystal growing apparatus used for manufacturing a semiconductor. This FZ method single crystal growing apparatus 30 is composed of a polycrystal set chamber 2 (hereinafter may be referred as a top chamber), zoning chamber 3, and single crystal take-out chamber 4 (hereinafter may be referred as a bottom chamber). Each chamber has a polycrystal set door 31, zoning opening 32, and single crystal take-out door 33 respectively. Also, a pantograph type elevating apparatus 34 having a work deck 35 is placed outside the chambers, and the deck has an apparatus control operation board 36 installed.

In order to grow a single crystal by using this FZ method single crystal growing apparatus 30, first of all, a tip portion of a polycrystal 16 set in the polycrystal set chamber 2 is placed in a induction-heating coil 15 connected to a radio-frequency supply unit 14 in the zoning chamber 3 by lifting down an upper shaft 12. Then, the tip portion of the polycrystal 16 is heated to melt, and a seed crystal is brought into contact with the tip portion from below for seeding. After necking that a lower shaft 13 is lifting down while it is rotated, a diameter of the crystal is gradually expanded to form a cone portion. Then, the polycrystal 16 is relatively moved versus the induction heating coil 15, and a melting zone 19 is sequentially moved toward the upward of the polycrystal 16, so that a single crystal 17 having target diameter can be grown. Therefore, crystallization proceeds from the lower tip end to the upper tip end of a polycrystalline silicon rod, and finally a single crystal rod can be obtained by separating the polycrystal from a silicon melt portion. By the way, the steps from lifting down a polycrystal to completion of a single crystal growth are called zoning.

Subsequently, before next zoning step starts, operation preliminary work such as taking out a single crystal, cleaning up each chamber, detaching and setting a induction heating coil, setting a polycrystalline raw material rod or the like are performed. These operations are comparatively unsafe and uncertain, since these operations are mostly performed by using the pantograph type elevating apparatus 34 having the work deck 35 and moving it to positions of each chamber door or opening, and a crystal is handled in high positions. Further, since an elevating apparatus has a number of moving parts or sliding parts, it causes to generate plenty of dust and is not suitable for being highly purified.

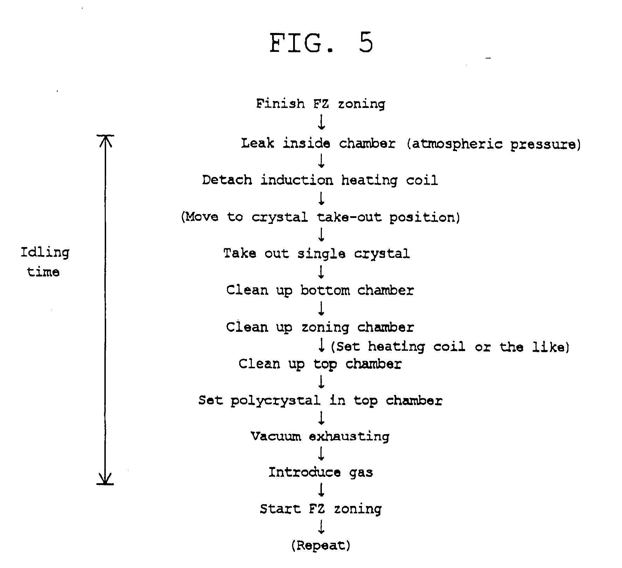

Fig. 5 shows a series of operation preliminary work flow. According to the drawing, since each operation step from leaking inside chambers to introducing gas by using the structure of the apparatus as aforementioned has to be performed in series, an idling time versus a zoning time is longer, and its productivity is inhibited.

Further, in order to prevent impurities and contaminants from entering into chambers by shutting out inside and outside of chambers, it is desirable that air filters are installed on the upper side of work planes (such as a door, opening or the like) of each chamber respectively. However, since work planes of each chamber are placed with the same aspect, it suffers from a problem that there is little space enough to install an air filter respectively.

A conventional FZ method single crystal growing apparatus can divide broadly into two categories that (1) chambers are provided for setting a raw material polycrystal, zoning, and taking out a single crystal respectively, and operations in a high position are preformed by operating a work deck on one pantograph type elevating apparatus as aforementioned, and (2) operations such as setting a raw material polycrystal, zoning, taking out a single crystal or the like are performed by one chamber and one work floor.

Since the latter one performs operations for such as setting a raw material polycrystal, zoning, taking out a single crystal, cleaning up the apparatus or the like by one chamber, respective work can not be performed at the same time. Therefore, an idling time (operation preliminary work time) becomes longer. Further, in order to take out a crystal from the chamber, since the chamber opening with the equal length or more to a crystal to be taken out is required, it is easy to enter contaminants into the zoning portion. Also, it suffers from a drawback that since the surface area of the inner wall of the chamber becomes large, the chamber is easily contaminated during zoning.

Nowadays, as a raw material polycrystal and single crystal rod are much heavier and longer, each chamber as aforementioned has been enlarged, and workers have been frequently required plenty of operations in high positions. Consequently, such as a pantograph type elevating operating deck, one chamber type or the like can not have dealt with the actual situation any longer.

### SUMMARY OF THE INVENTION

The present invention has been accomplished to solve the above-mentioned problems, and an object of the present invention is to provide an FZ method single crystal growing apparatus, wherein in order to avoid a risk of operations in high positions, resulting that a raw material polycrystal and single crystal rod are much heavier and longer, to clean up a single crystal growing atmosphere and work environment, and to reduce an idling time, problems as for the apparatus are solved, so that reliability of work can be improved, and power saving and improvement of productivity can be achieved.

To solve the above problems, the present invention provides a single crystal growing apparatus by a floating-zone method (FZ method) characterized by comprising at least a polycrystal set chamber, zoning chamber, single crystal take-out chamber, and three work floors, which are installed near the chambers and corresponding to positions of at least each work plane for setting a polycrystal, zoning, and taking out a single crystal.

By using thus composed FZ method single crystal growing apparatus, operations such as setting a raw material polycrystalline rod, growing a single crystal, taking out a single crystal rod, cleaning up the apparatus or the like are performed, so that workers can be free from operations in high positions, and they can work on a large work floor in a stable posture. Accordingly, reliability of operations can be improved, and workers can work safely. Also, predetermined work in each floor can be performed in parallel at almost the same time, and thereby, in the case of the aforementioned operation preliminary work, working time can be reduced, and thereby improvement of productivity can be achieved.

In this case, work planes for the polycrystal set chamber and single crystal take-out chamber can be installed with different aspect from a work plane for zoning chamber.

As described above, for example, in the case that an opening for setting a polycrystal in the polycrystal set chamber is installed as a work plane, if an opening for taking out a single crystal from the single crystal take-out chamber is installed with the same aspect as the work plane, besides, especially installed with the different aspect from the zoning chamber work plane, each work plane can perform respective work in parallel during an idling time except a single crystal growing time by zoning, and thereby the idling time can be reduced. Therefore, the total time for the singe crystal growing, which is a single crystal growing time and an idle time in one cycle, can be reduced, and improvement of productivity can be achieved. At this point, respective work means, for example, setting a raw material polycrystal in the polycrystal set chamber, taking out a single crystal in the single crystal take-out chamber, cleaning up inside the chamber, and detaching, cleaning, and setting a induction heating coil or the like in the zoning chamber.

In this case, the work planes of the polycrystal set chamber and single crystal take-out chamber can be placed on the position rotated at an angle of 90 or 180 on the basis of the zoning chamber work plane.

If the work planes have the above-described positional relationship, each work plane has little interference, and each work floor has also little interference. Therefore, the apparatus can be easily composed, and the operations can be carried out smoothly and efficiently on each work plane and each work floor.

Further, air curtains can be provided on the upper side of each work plane for setting a polycrystal, zoning, and taking out a single crystal respectively.

Since the floors are installed in the positions corresponding to each work plane of each chamber, air curtains can be provided respectively on the upper side of each work plane. As the result of-this, inside and outside of an FZ method furnace can be screened, so that the FZ method single crystal growing apparatus can prevent impurities and foreign materials from entering into each chamber.

As described above, according to the FZ method single crystal growing apparatus of the present invention, since three layered structural work floor is installed near each chamber of at least a polycrystal set chamber, zoning chamber, and single crystal take-out chamber, workers can be free from the conventional work in high positions and can be secured from an increasing risk, resulting that a crystal is much heavier and longer, and improvement of reliability and power saving of work can be achieved.

Also, operation preliminary work such as setting a polycrystal, taking out a single crystal, and cleaning up an apparatus can be performed in parallel at almost the same time in each floor, and thereby the idling time can be reduced so as to improve its productivity. Further, since air curtains are provided on the upper side of each chamber work plane, inside of each chamber can be highly purified, and quality of a crystal to be produced can be improved.

### BRIEF DESCRIPTION OF THE DRAWINGS

Fig. 1 is a schematic view of an FZ method single crystal growing apparatus of the present invention having work floors installed.

Fig. 2 is an explanatory view of an inner furnace construction of the FZ method single crystal growing apparatus.

Fig. 3 is an explanatory flow of an idling time in the case of using the FZ method single crystal growing apparatus of the present invention.

Fig. 4 is a schematic view of the FZ method single crystal growing apparatus having a conventional pantograph type elevating work deck installed.

Fig. 5 is an explanatory flow of an idling time in the case of using a conventional pantograph type work deck.

### DESCRIPTION OF THE INVENTION AND A PREFERRED EMBODIMENT

Embodiments of the present invention will now be described. However, the present invention is not limited thereto.

The inventors of the present invention have found that, for example, in a conventional FZ method silicon single crystal growing apparatus, when a raw material polycrystalline rod was set in a polycrystal set chamber, a worker adjusted a pantograph type elevating work deck in the position of a polycrystal set chamber door, and might be forced unsafe work in an unstable posture on a high place deck. Thus cause have been investigated and made clear, then it has been found that since a crystal is much heavier and longer recently, each chamber is accordingly enlarged, and therefore, a worker is frequently required to work in a high position around chambers. The present invention has been completed to solve that problem.

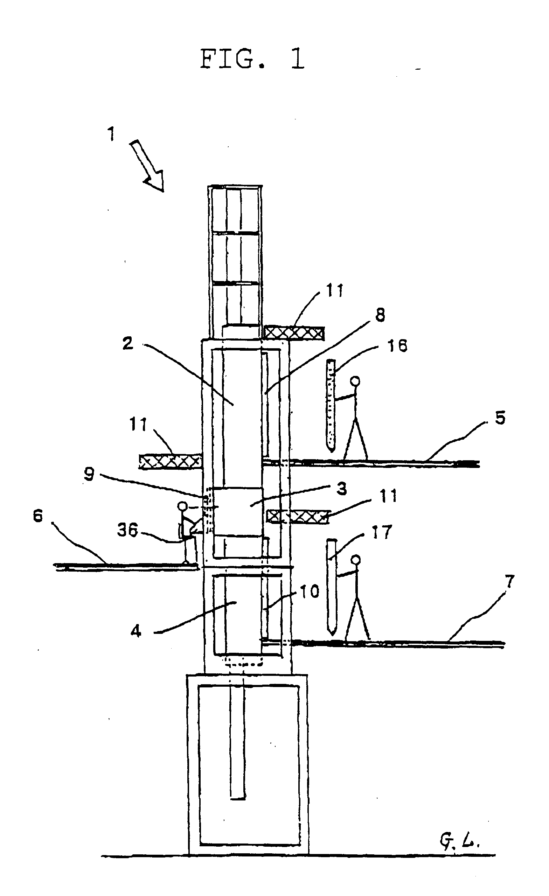

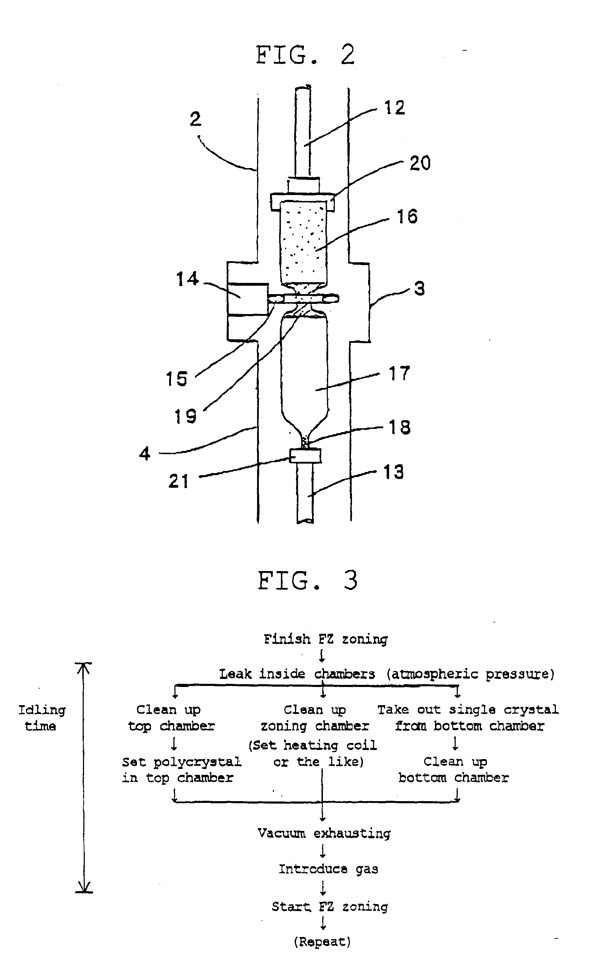

First, a example of an FZ method single crystal growing apparatus of the present invention will now be described according to a schematic view of Fig. 1 and an inner constructional drawing of a chamber of Fig. 2. As shown in Fig. 1, the FZ method single crystal growing apparatus 1 of the present invention is composed of a polycrystal set chamber 2, zoning chamber 3, and single crystal take-out chamber 4 from the top. Each chamber has a polycrystal set chamber work plane 8, zoning chamber work plane 9, and single crystal take-out chamber work plane 10. For example, each chamber is provided such as a door, opening, bellows or the like.

Also, a polycrystal set work floor 5, zoning work floor 6, and single crystal take-out work floor 7 are provided near each chamber, and each floor is connected through such as stairs, elevator (not shown) or the like. As described above, the present invention has work floors of at least three layered structure. By using thus floor structure, if operations such as setting a raw material polycrystalline rod, taking out a single crystal rod, cleaning/doing maintenance of the apparatus or the like are performed, different operations in each floor can be performed without interference at almost the same time. Further, workers can work on a large work floor in a stable posture, and thereby reliability of operations can be improved, and workers can be secured.

According to an example of Fig. 1, the positions of the polycrystal set chamber work plane 8 and single crystal take-out chamber work plane 10 are placed at an angle of 180 on the basis of the zoning chamber work plane 9. It is preferable that the relative location between them is at an angle of 90 or 180, but it is not limited thereto.

As described above, if two work planes handling two kinds of the crystal are installed with the same aspect, besides, they are installed with the different aspect from the zoning chamber work plane, operations at each work plane can be performed without interference in parallel at the same time. Especially, since operations at the zoning chamber work plane are mostly different from those of two work planes handling two kinds of the crystal, it is extremely available for improving safety and reliability of operations.

Further, an air curtain with a HEPA filter 11 is installed on the upper side of each work plane 8, 9, and 10 for setting a polycrystal, zoning, and taking out a single crystal.

The HEPA filter uses a air filter whose general performance is that the particle collection trapping rate is 99.97% or more versus particles whose diameter is 0.3 *µ* m in rated air-flow, and initial pressure loss is 300Pa or less. However, other air cleaning filter can be used in accordance with its object.

Since floors are installed in the positions corresponding to each work plane of each chamber, and the work planes of each chamber are placed on respective positions, such air filters can be installed locally. Therefore, cleaning efficiency can be more improved than the case that the whole factory building is made as a clean room. And when the apparatus is installed in a clean room, cleanness of work sections can be improved effectively. As the result of this, the chambers can be prevented impurities and contaminants from entering by screening inside and outside of the chambers. A conventional pantograph type apparatus can not have been performed such work.

Next, an inner furnace construction will now be described. Inside of the polycrystal set chamber 2 has a polycrystal 16, polycrystal holder 20 for holding the polycrystal 16, an upper shaft 12 for elevating the holder, and an elevating apparatus (not shown) provided. A zoning chamber 3 has a radio-frequency supply unit 14 and induction heating coil 15 installed. A single crystal take-out chamber 4 has a seed crystal holder 21 for holing a seed crystal 18, a lower shaft 13 for rotating and elevating the holder, and an elevating apparatus (not shown) provided.

Next, a single crystal growing method and a clean-up and maintenance of the apparatus in the FZ method single crystal growing apparatus 1 of the above described present invention will now be described.

First, a tip of the polycrystal 16 is placed inside the radio-frequency induction heating coil 15 in the zoning chamber 3 by lifting down the upper shaft 12. Then, the temperature of the tip of the polycrystal rod is raised by radiant heating that carbon is heated by radio-frequency, or by radiant heating such as infrared lamp, and thereby the polycrystal becomes a good conductor in terms of radio-frequency. The polycrystal rod is further heated to melt, and the seed crystal 18 is brought into contact with the tip for seeding by lifting up the lower shaft 13. After so-called necking (necking: for example, diameter: about 3mm, length: about 30mm) that the seed crystal 18 is lifting down by the lower shaft 13 while it is rotated, a diameter of the crystal is gradually expanded to form a cone portion, a single crystal having target diameter is grown.

In the case of this crystal growth, a computer controls input and output of electric power supplied to the radio-frequency coil so as not to solidify or drop of the melt. A melting zone 19 is sequentially moved to the upper portion of the polycrystalline rod, and the seed crystal is vertically moved downward while it is rotated in accordance with the growth of the single crystal. Therefore, single-crystallization proceeds from the lower tip end to the upper tip end of the polycrystalline raw material rod, and when the crystallization reaches at a predetermined portion, a single crystal rod can be obtained by separating the polycrystal from the melt portion. The single crystal growing steps by a FZ method so far are called zoning. An apparatus control operation board 36 is installed on the zoning work floor 6.

Following that, operation preliminary work such as taking out a single crystal, cleaning and doing maintenance the apparatus, setting a raw material polycrystal or the like is performed to prepare next zoning.

Fig. 3 shows a series of an operation preliminary work flow according to the FZ method single crystal growing apparatus of the present invention. It is clear from the drawing that the present apparatus has work floors, which are at least three layered structure, installed in each chamber, and each work plane is placed, so that respective work should not be interfered. Therefore, operations of each chamber such as cleaning up the inside of chambers, inspection/replacement of parts, taking out a single crystal, setting a polycrystal or the like can be performed in parallel at almost the same time on each work floor through each work plane, and thereby an idling time versus a zoning time can be considerably reduced. As the result, the operating rate of the single crystal growing apparatus is raised and its productivity can be improved.

In the case of the take-out operation of a single crystal rod, the single crystal is carried out from the single crystal take-out chamber 4 after the single crystal rod is cooled enough to be handled.

Also, setting of a polycrystal is generally preformed at the end of operation preliminary work that the polycrystal is set in the polycrystal holder 20 inside the polycrystal set chamber 2. Further, the seed crystal 18 is set in the seed crystal holder 21 inside the single crystal take-out chamber 3.

After the setting of a polycrystal and seed crystal, operation preliminary work is completed by such as vacuum exhausting, introducing inert gas or the like in order to prepare for next zoning work.

The present invention is not limited to the above-described embodiments. The above-described embodiments are mere examples, and those having the substantially same structure as that described in the appended claims and providing the similar action and effects are included in the scope of the present invention.

For example, according to the above-described embodiments, it has been explained that the air curtain with a HEPA filter is installed on the upper side of each work plane for setting a polycrystal, zoning, and taking out a single crystal. However, the present invention is not limited thereto, and it is also possible in accordance with its object that it can be installed only for taking out a single crystal, or in the case that the whole factory building is made as a clean room, it may be installed a air curtain with a HEPA filter of large size provided near the ceiling of the building. In relation to a filter, it is not limited a HEPE filter.

## Claims

1. An single crystal growing apparatus by a floating-zone method (FZ method) characterized by comprising at least a polycrystal set chamber, zoning chamber, single crystal take-out chamber, and three work floors, which are installed near the chambers and corresponding to positions of at least each work plane for setting a polycrystal, zoning, and taking out a single crystal.

2. The FZ method single crystal growing apparatus according to Claim 1, characterized in that work planes of the polycrystal set chamber and single crystal take-out chamber have different aspect from the zoning chamber work plane.

3. The FZ method single crystal growing apparatus according to Claim 1 or 2, characterized in that the work planes are placed on a position rotated at an angle of 90 or 180 on the basis of the zoning chamber work plane.

4. The FZ method single crystal growing apparatus according to one of claim 1 to claim 3, characterized in that air curtains are installed in an upper side of each work plane for setting a polycrystal, zoning, and taking out a single crystal.
